# EUROPÄISCHE PATENTSCHRIFT

(11) **EP 1 038 109 B1**
(45) Veröffentlichungstag und Bekanntmachung des Hinweises auf die Patenterteilung: **01.02.2006**
(21) Anmeldenummer: 99944375.7
(22) Anmeldetag: 11.08.1999
(51) Int. Cl.: F16B 5/00, F16B 45/00, H01R 13/508

(54) **ELEKTRISCHES GERÄT MIT EINEM VERBINDUNGSCLIP UND EINER VERBINDUNGSCLIPAUFNAHME ZUR VERBINDUNG MIT EINEM ZWEITEN ELEKTRISCHEN GERÄT**
ELECTRIC DEVICE WITH A CONNECTION CLIP AND A RECEIVING FIXTURE FOR A SECOND ELECTRIC DEVICE
APPAREIL ELECTRIQUE A CLIP DE RACCORDEMENT ET LOGEMENT DE CLIP DE RACCORDEMENT POUR LE RACCORDEMENT A UN DEUXIEME APPAREIL ELECTRIQUE

(30) Priorität: 09.10.1998 DE 19846577
(43) Veröffentlichungstag der Anmeldung: 27.09.2000
(73) Patentinhaber: AEG Niederspannungstechnik GmbH & Co. KG, 24534 Neumünster (DE)
(72) Erfinder: HILLEBRAND, Dietmar, D-31838 Bad Münder (DE); PRIES, Jürgen, D-31785 Hameln (DE); HEINDORF, Helmut, D-31785 Hameln (DE)
(74) Vertreter: TBK-Patent
(86) Internationale Anmeldenummer: PCT/EP1999/005894
(87) Internationale Veröffentlichungsnummer: WO 2000/022305

(56) Entgegenhaltungen:
- DE-A- 1 927 722
- US-A- 2 702 866
- US-A- 4 502 807
- US-A- 4 826 348

## Beschreibung

Die vorliegende Erfindung bezieht sich auf eine Verbindungseinrichtung zur Verbindung mehrerer Einzelkomponenten, insbesondere zur Verbindung von zwei elektrotechnischen Einzelkomponenten oder Elektrogeräten. Eine solche Verbindungseinrichtung besteht aus einem Verbindungsclip, der zwei Einzelkomponenten miteinander verbindet, aus einer Verbindungsclipaufnahme, die an jeweils einer der zu verbindenden Einzelkomponenten vorgesehen ist, sowie aus einer Eingriffsaufnahme, die ebenfalls in einer zu verbindenden Einzelkomponente vorgesehen ist, um einen Verbindungsclip in Eingriff zu bekommen, um zwei Einzelkomponenten zu verbinden. Dadurch wird ein System Verbindungsclip/Verbindungsclipaufnahme gebildet, das die Verbindungseinrichtung darstellt.

Bei der Installation elektrotechnischer Komponenten ist es oftmals notwendig, zwei Einzelkomponenten miteinander zu verbinden, da sie entweder gemeinsam wirken oder in einer großen Anzahl nebeneinander in Schaltkästen etc. installiert werden müssen.

Es soll jedoch bereits hier angemerkt werden, daß die Verwendung nicht allein auf die Verbindung elektrotechnischer Bauelemente beschränkt ist. Vielmehr wird hier nur beispielhaft auf diesen Bereich eingegangen, da die derzeitig bevorzugten Ausführungsbeispiele in diesem Bereich angesiedelt sind.

In der Elektrotechnik ist es beispielsweise üblich, zwei Einzelkomponenten über Bügelfederklammern oder sogenannte Brillenfedern miteinander zu verbinden. Eine solche Bügel- oder Brillenfeder besteht aus einem Federstahl, der an seinen beiden Enden spiralförmig eingerollt ist. Diese beiden eingerollten Endabschnitte werden dann jeweils in entsprechende Ausnehmungen, die in den zu verbindenden Einzelkomponenten vorgesehen sind, eingesetzt, wobei die Abmessungen dergestalt sind, daß das Einsetzen nur unter einem gewissen Druck möglich ist, so daß die Bügel- oder Brillenfeder in die Ausnehmungen quasi einschnappt, um eine sichere Verbindung zu gewährleisten.

Die Montage dieser Bügelfederkonstruktion ist jedoch schwierig und verlangt einiges handwerkliches Geschick, was zu einer längeren Montagezeit und somit teureren Herstellkosten führt. Weiterhin werden Fixierteile (z.B. Ringe oder Scheiben) zwischen den zu verbindenden Geräten benötigt, die zusätzliche Kosten verursachen. Außerdem kann die Bügelfeder leicht verloren gehen, da sie ein kleines, separates Bauteil ist, das bis zur Montage lose mitgeführt wird.

Aus der US-A-4 502 807 ist ein Verbindungshaken zum Verbinden von zwei Bauteilen bekannt, der einen stabartigen Grundkörper aufweist, an dessen Ende mittels einer Drehachse ein Drehfuß ausgebildet ist. Weiterhin ist am gegenüberliegenden Ende des Stabes dieses Verbindungshakens ein Ankerhaken ausgebildet, der sich quer zum stabförmigen Grundkörper erstreckt. Bei diesem Verbindungshaken ist die Drehachse quer zur Ausrichtung des Ankerhakens und weiterhin quer zur Ausrichtung des stabförmigen Grundkörpers vorgesehen.

Aufgabe der Erfindung ist es, einen neuartigen Verbindungsclip zu schaffen, der es erlaubt, an ein Hauptgerät wahlweise links und/oder rechts ein Hilfsgerät montieren zu können.

Diese Aufgabe wird durch die Merkmale des Anspruchs 1 gelöst. Gemäß Anspruch 1 weist der Verbindungsclip einen Ankerbalken auf, der beidseitig mit einem bauchigen Einschnappabschnitt versehen ist, um an ein entsprechendes Gerät eingeschnappt werden zu können.

Weiterhin soll mit der Erfindung eine Verbindungsclipaufnahme zur Aufnahme eines derartigen Verbindungsclips geschaffen werden sowie eine Eingriffsaufnahme mit einem derartigen verbindungsclip, weiterhin ein elektrisches Bauteil mit einer Verbindungseinrichtung, die einen derartigen Verbindungsclip aufweist. Dies wird durch die Merkmale der Ansprüche 5, 7 und 16 geschaffen.

Durch die vorteilhafte Ausgestaltung, daß der Verbindungsclip in einer hinterschnittenen Nut in einer zu verbindenden Einzelkomponente von deren rechten Rand einer Seite bis zum linken Rand dieser Seite verschiebbar gelagert ist, ist nur ein einziger Verbindungsclip notwendig, mit dem es möglich ist, eine zu verbindende Einzelkomponente wahlweise links oder rechts anzukoppeln, je nachdem, auf welcher Seite die Verbindung gerade benötigt wird.

Durch das Vorsehen eines über die Dicke des Verbindungsclips hinausragenden Begrenzungszapfens am Stab des Verbindungsclips kann der Ankerbalken des Verbindungsclips nicht vollständig in der hinterschnittenen Nut innerhalb des zu verbindenden Bauteils verschwinden. Außerdem kann der Begrenzungszapfen beim Zusammenklemmen der zwei zu verbindenden Bauteile zur Führung der Bewegung dienen.

Der Verbindungsclip kann vorzugsweise so gestaltet sein, daß er leicht handhabbar ist, so daß die Verbindungseinrichtung auch leicht wieder gelöst werden kann. Dies geschieht beispielsweise durch eine geeignete Ausgestaltung des Ankerbalkens, beispielsweise durch eine Kerbe in der Mitte des Ankerbalkens, in die bei Demontage des Gerätes z. B. die Spitze eines Schraubendrehers angesetzt und der Verbindungsclip somit leicht gelöst werden kann.

Die Verbindungsclipaufnahme kann in einem Formvorgang so gestaltet werden, daß sie an mindestens zwei Montageseiten für die Verbindung einer weiteren Komponente sowohl mit einer rechtwinkligen Anlage für den Drehfuß des Verbindungsclips, als auch mit einem Hinterschnitt zur Aufnahme des Einschnappabschnitts des Ankerbalkens des Verbindungsclips ausgestaltet ist. Dadurch ist die Verbindungseinrichtung multifunktionell, da sie je nach Bedarf als Verbindungsclipaufnahme zur Aufnahme des Einschnappbereiches des Ankerbalkens des Verbindungsclips oder als Aufnahme für den Drehfuß des Verbindungsclips dienen kann. Dadurch wird die Herstellung der Verbindungseinrichtung vereinfacht und die Herstellkosten können reduziert werden.

Gemäß einem weiteren Aspekt der Erfindung ist es möglich, die Verbindungsclipaufnahme multifunktionell zu gestalten. Dadurch können verschiedene Verbindungsclips wahlweise verwendet werden, um zwei Bauteile miteinander zu verbinden.

Im folgenden soll die Erfindung anhand bevorzugter Ausführungsbeispiele unter Bezugnahme auf die beigefügten Zeichnungen näher erläutert werden.

Fig. 1 zeigt eine perspektivische Ansicht eines Verbindungsclips.

Fig. 2 ist eine perspektivische Ansicht zweier zu verbindender Einzelkomponenten sowie des Verbindungsclips, wobei beide Einzelkomponenten teilweise ausgebrochen dargestellt sind und eine der Einzelkomponenten darüber hinaus nur teilweise dargestellt ist.

Fig. 3 zeigt dieselbe Ansicht wie Fig. 2, wobei sich jedoch der Verbindungsclip in seinem eingeschnappten Zustand befindet.

Fig. 4 zeigt eine andere perspektivische Darstellung von Fig. 3.

Fig. 5 zeigt einen Verbindungsclip, der nicht zur Erfindung gehört, jedoch in einem zweiten Ausführungsbeispiel einer erfindungsgemässen Verbindungsclipaufnahme bzw. Eingriffsaufnahme Verwendung findet.

Fig. 6 ist eine perspektivische Darstellung des Verbindungsclips aus Fig. 5 und einer Verbindungsclipaufnahme gemäß einem zweiten Ausführungsbeispiel.

Fig. 7 ist eine Schnittdarstellung, die zwei zu verbindende Bauteile teilweise zeigt, die mit dem Verbindungsclip gemäß Fig. 5 verbunden sind.

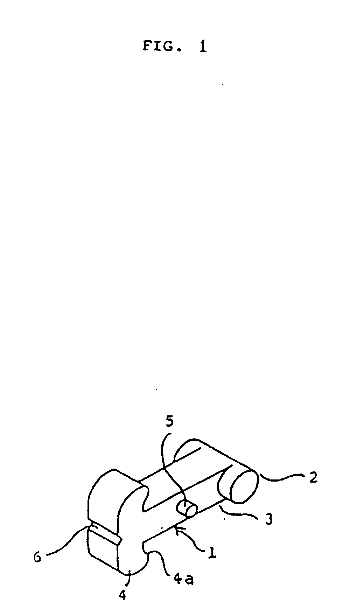

Es folgen Ausführungen zu einem ersten Ausführungsbeispiel unter Bezugnahme auf die Fig. 1 bis 4.

Unter Bezugnahme auf Fig. 1 soll nun der Verbindungsclip 1 näher erläutert werden.

Der Verbindungsclip 1 hat einen im wesentlichen ankerförmigen Aufbau, der einen Stab 3 sowie einen Ankerbalken 4 aufweist, der sich quer über ein Ende des Stabs erstreckt. Sowohl der Stab 3 als auch der Ankerbalken 4 sind flach ausgebildet und haben einen rechteckigen Querschnitt. Am anderen Ende des Stabs, gegenüber dem Ankerbalken 4, befindet sich ein Drehfuß 2, der als runder Wellenabschnitt ausgeformt ist, der links und rechts vom Stab 3 seitlich vorsteht. Die Drehachse des Drehfußes steht senkrecht zur Längsachse des Ankerbalkens 4. Außerdem ist die Drehachse des Drehfußes 2 quer zur Längserstreckung des Ankerbalkens 4 ausgerichtet. Etwa in der Mitte des Stabs 3 ist ein Zapfen 5 vorgesehen, der sich parallel zur Drehachse des Drehfußes 2 erstreckt und somit ebenfalls seitlich von dem Stab 3 etwas vorsteht. Der Ankerbalken 4 hat einen leicht gekrümmten, bauchigen Einschnappabschnitt 4a, der sich zum Stab 3 hin krümmt. Dieser Einschnappabschnitt 4a dient als Einschnappelement bei der Montage. Oben in der Mitte des Ankerbalkens, auf der dem Stab abgewandten Seite, ist eine Kerbe 6 vorgesehen.

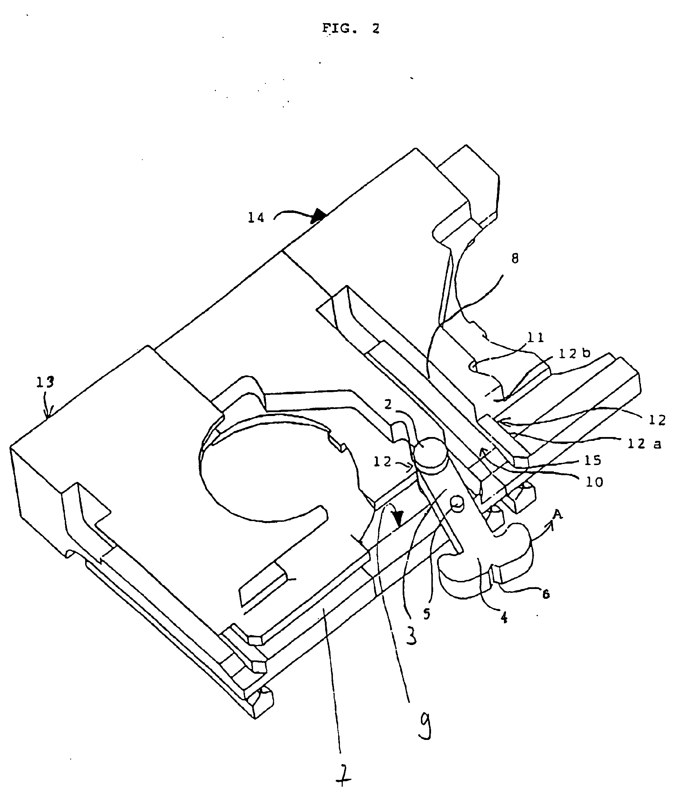

Wie in Fig. 2 zu sehen ist, sind mit 13 und 14 zwei zu verbindende Bauteile bezeichnet, wobei beispielsweise das Bauteil 14 ein Hauptgerät ist, und das Bauteil 13 ein Hilfsgerät ist, das an das Hauptgerät montiert werden muß.

In jedem der beiden zu verbindenden Bauteile 13 und 14 sind jeweils eine Verbindungsclipaufnahme sowie zwei jeweils links und rechts in der Verbindungsclipaufnahme vorgesehene Ausnehmungen 11 vorgesehen.

Im folgenden wird die Verbindungsclipaufnahme beschrieben.

Wie aus Fig. 2 hervorgeht, ist an einer Seite des Bauteils 13 und 14 eine Nut 7 vorgesehen, die sich über die gesamte Seitenlänge hin erstreckt. Die Nut 7 ist an beiden Seitenenden offen. In der Nut ist eine Hinterschneidung 9 vorgesehen, so daß die Nut 7 zusammen mit der Hinterschneidung 9 eine Art Führungsnut bildet, in der der Drehfuß 2 des Verbindungsclips 1 aufgenommen ist und nach links und rechts gleitend verschieblich gelagert ist. Dabei befindet sich der Drehfuß 2 in der Hinterschneidung 9, während der Stab 3 in der Nut 7 geführt wird. Der Ankerbalken 4 befindet sich außerhalb der Nut 7. Dadurch, daß der Drehfuß 2 in der Hinterschneidung 9 geführt wird, kann der Verbindungsclip unmöglich aus der Nut herausfallen, so daß er nicht mehr verlorengehen kann. Der Zapfen 5 verhindert, daß der Ankerbalken 4 versehentlich durch die Nut 7 ins Innere des Bauteils 13 geraten kann, da er dann nicht mehr von außen zugänglich wäre.

Im folgenden wird die Eingriffsausnehmung in den Bauteilen 13 und 14 beschrieben.

Diese dient dazu, den Einschnappabschnitt 4a des Verbindungsclips 1 aufzunehmen und festzuhalten. Dazu ist im Inneren, jeweils links und rechts auf der Seite der Nut 7 der Bauteile 13, 14 eine Ausnehmung 11 ausgebildet. Diese Ausnehmung 11 ist im wesentlichen korrespondierend zur Gestalt des Einschnappabschnitts 4a des Ankerbalkens ausgebildet. D.h. sie besteht aus einer Anlagefläche, die sich in etwa senkrecht zur Erstreckung der Nut 7 ins Innere des Bauteils 13, 14 hinein erstreckt. Diese Anlagefläche hat am Ende eine Hinterschneidung, die in etwa der Form des bauchigen Einschnappabschnitts 4a des Verbindungsclips 1 entspricht. Bei der Montage der beiden zu verbindenden Bauteile kann der Einschnappabschnitt 4a in die Ausnehmung 11 einschnappen und in die Hinterschneidung einrasten. Je nach Ausgestaltung der Ausnehmung und Einstellung der Materialflexibilität des Verbindungsclips kann die Einrastfunktion von sehr streng und schwer wieder lösbar bis sehr leicht und leicht lösbar eingestellt werden.

Im folgenden wird die Verbindung der beiden Bauteile 13, 14 durch den Verbindungsclip 1 beschrieben.

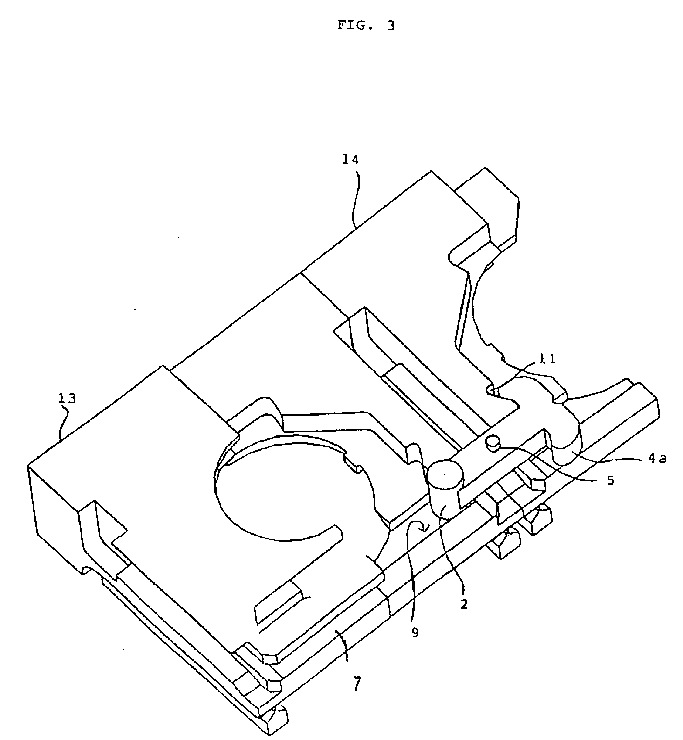

Fig. 2 zeigt eine Darstellung, wo der Verbindungsclip 1 in einem zu verbindenden Bauteil 13 angeordnet ist, und sich in seiner geöffneten Position befindet. Das mit dem Bauteil 13 zu verbindende Bauteil 14 befindet sich in einer Anlageposition, in der die beiden Bauteile miteinander verbunden werden sollen. Genauer gesagt, ist der Drehfuß 2 des Verbindungsclips 1 in einer rechtwinkligen Drehlagerung 12 des einen zu verbindenden Bauteils 13 angeordnet. Zum leichteren Verständnis ist die obere Abdeckung des zu verbindenden Bauteils 13, in dem sich der Verbindungsclip 1 befindet, teilweise ausgebrochen, so daß der Verbindungsclip vollständig zu sehen ist. In Wirklichkeit befindet sich der Stab 3 des Verbindungsclips 1 natürlich zusammen mit seinem Drehfuß 2 im Inneren des zu verbindenden Bauteils 13 und nur ein Teil des Stabs 3 und der Ankerbalken 4 ragen aus einer schlitzartigen Öffnung der Nut 7 aus dem zu verbindenden Bauteil 13 hervor. Der Verbindungsclip 1 ist um seinen Drehfuß 2 drehbar. Wird nun der Verbindungsclip 1 um den Drehfuß 2 in Pfeilrichtung A aus Fig. 2 gedreht, gelangt der Verbindungsclip mit dem zweiten zu verbindenden Bauteil 14 in Eingriff, wie in Fig. 3 gezeigt ist. In Fig. 3 befindet sich der Verbindungsclip 1 in seiner geschlossenen Position.

Wie anhand der Figuren 2 und 3 ersichtlich ist, sind die beiden Bauteile 13 und 14 hinsichtlich der Ausgestaltung für die Aufnahme eines Verbindungsclips gleich ausgestaltet. D.h. man kann völlig flexibel wahlweise den Verbindungsclip 1 des Bauteils 13 zur Verbindung mit dem Bauteil 14 mit der dort vorgesehenen, dazu korrespondierenden Aufnahme in Eingriff bringen und umgekehrt könnte man einen Verbindungsclip, der in dem Bauteil 14 vorgesehen ist, mit der in dem Bauteil 13 vorgesehenen Aufnahme in Eingriff bringen. Mit dem Bezugszeichen 12 ist eine Drehfußlagerung bezeichnet, die dazu dient, den Drehfuß 2 in zwei Richtungen abzustützen, wobei der Verbindungsclip 1 um die Achse des Drehfußes 2 drehbar bleibt. Die Drehfußlagerung 12 wird aus einem Wandabschnitt 12a und einem weiteren Wandabschnitt 12b gebildet. Der Wandabschnitt 12a ist nicht so hoch wie der Wandabschnitt 12b ausgebildet. Der Wandabschnitt 12a wird gebildet, indem die Hinterschneidung 9 der Nut 7 vor dem Ende der Nut aufhört. Der Wandabschnitt 12a ist notwendig, damit der Drehfuß 2 in Anlage daran gelangen kann, der Stab 3 aber über diesen Wandabschnitt 12a hinweggleiten kann, damit der Verbindungsclip 1 so verschwenkt werden kann, um überhaupt in das zu verbindende Bauteil 14 eingreifen zu können (s. Fig. 2 und 3). Der Wandabschnitt 12b ist so hoch ausgebildet, daß auch der Stab 3 in Anlage an diesen Wandabschnitt gelangt, so daß die Drehung des Verbindungsclips durch diesen Wandabschnitt begrenzt wird. Damit wird sichergestellt, daß der Verbindungsclip nicht weiter nach innen schwenken kann, wo er unter Umständen für das Montagepersonal nicht mehr zugänglich ist.

Im Anschluß an den Wandabschnitt 12b befindet sich im rechten Winkel dazu die Ausnehmung 11 mit der Hinterschneidung, die korrespondierend zu einer Einschnappseite des Einschnappabschnitts 4a des Ankerbalkens 4 des Verbindungsclips 1 ausgestaltet ist. Wenn nun der Verbindungsclip 1 um die Drehachse seines Drehfußes 2 herum gedreht wird, wie in den Fig. 2 und 3 zu sehen ist, kann der Verbindungsclip so lange gedreht werden, bis er mit einer Anlagefläche seines Stabes 3 in Anlage mit dem Wandabschnitt 12b gerät und der gekrümmte Einschnappabschnitt 4a in die Hinterschneidung der Ausnehmung 11 einschnappt. Dieser Zustand ist in Fig. 3 gezeigt. In diesem Zustand werden im vorliegenden Ausführungsbeispiel Hilfs- und Hauptgerät 13, 14 fest miteinander verbunden. Die Abmessungen des Verbindungsclips in Verbindung mit einer geeigneten Wahl der Abmessungen der Ausnehmung 11 in dem zu verbindenden Bauteil sind so gewählt, daß der Verbindungsclip beim Einführen die beiden zu verbindenden Bauteile miteinander verspannt.

Wie in Fig. 3 zu erkennen ist, ragt der dem eingeschnappten Einschnappabschnitt 4a gegenüberliegende Einschnappabschnitt 4a des Ankerbalkens des Verbindungsclips in die Nut 7 des Hilfsgeräts 14, durch den der Verbindungsclip 1 nach innen geschwenkt werden konnte. Dadurch bleibt der Verbindungsclip auch in seiner geschlossenen Stellung von außen zugänglich, zumindest für ein Hilfswerkzeug, wie beispielsweise einen kleinen Schraubendreher. Dadurch kann die Verbindung der beiden Bauteile wieder gelöst werden. Somit ist das Hilfsgerät leicht an dem Hauptgerät anbringbar und ebenso leicht wieder davon lösbar.

Wie beispielsweise aus den Fig. 1 und 2 hervorgeht, ist der Verbindungsclip auf dem Ankerbalken 4 in der Mitte, gegenüber dem Stab 3, mit einer V-förmigen Kerbe 6 ausgestattet. Diese Kerbe 6 erlaubt eine noch leichtere Lösung des Verbindungsclips mittels einem Hilfswerkzeug, um die in die Hinterschnitte 11 eingeschnappten Einschnappabschnitte 4a aus der geschlossenen Position in die geöffnete Position zu bewegen. Beispielsweise kann mit einem kleinen Schraubendreher leicht in die Kerbe eingegriffen werden und somit der Verbindungsclip herausgedrückt werden.

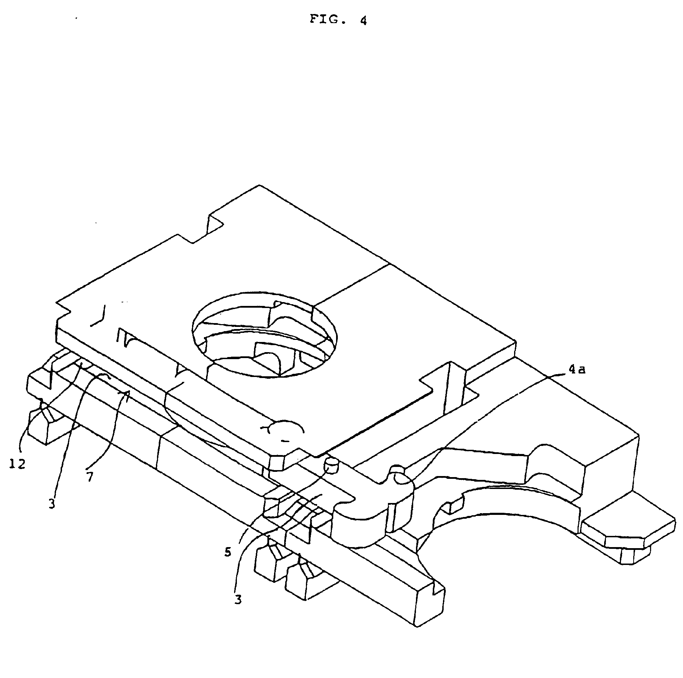

Wie ferner beispielsweise aus Fig. 4 hervorgeht, wo das Hilfsgerät vollständig gezeigt ist (d.h. ohne teilweise Ausbrüche), ist der Verbindungsclip innerhalb der Nut 7 von rechts nach links und umgekehrt frei verschiebbar, so daß er wahlweise von einer Drehfußlagerung 12 an einer Seite zu einer weiteren an der anderen Seite verschoben werden kann. Dadurch kann an das Hilfsgerät 13 wahlweise links und/oder rechts ein Hauptgerät 14 montiert werden. Dadurch wird eine maximale Flexibilität bei der Montage gewährleistet.

Wie des weiteren aus Fig. 2 hervorgeht, dient der Zapfen 5 am Verbindungsclip 1 dazu, zu verhindern, daß der Verbindungsclip versehentlich vollständig in der Nut 7 des zu verbindenden Bauteils 13 verschwindet, wenn sich der Verbindungsclip irgendwo in der Mitte der Nut 7 befindet, indem der Zapfen 5 an die die Nut 7 bildenden Wände des Bauteils 13 anschlägt. Dadurch kann der Ankerbalken 4 des Verbindungsclips nicht vollständig nach innen in das Bauteil eingeschwenkt werden, d.h. sein Drehbereich ist im mittleren Bereich, d.h. dem nicht seitlichen Bereich, stärker begrenzt als in den Seitenbereichen, wo die Nut 7 offen ist und eine Verschwenkung des Verbindungsclips 1 zuläßt, bis der Stab 3 an der Anlagefläche 12b in Anlage gelangt.

Zusätzlich ist jeweils seitlich an den angrenzenden Seitenflächen der zu verbindenden Bauteile 13, 14 eine abschnittsweise Zurücksetzung 8 vorgesehen. Werden zwei zu verbindende Bauteile aneinandergelegt, so entsteht aus den beiden angrenzenden abschnittsweisen Zurücksetzungen 8 eine Nut 10. Wenn der Verbindungsclip in die geschlossenen Position gebracht wird, d.h. wenn der Verbindungsclip in seine geschlossene Position verschwenkt wird (in Pfeilrichtung A in Fig. 2), schwenkt der bereits beschriebene Zapfen 5 in diese Nut 10 ein. Dadurch behindert der Zapfen 5 zum einen die Montage der beiden zu verbindenden Bauteile nicht, und zum anderen kann er zusätzlich zur Führung dienen. Um es dem Zapfen 5 überhaupt zu ermöglichen, in die Nut 10 eingeschwenkt zu werden, sind an den Ecken jeweils Montagehilfsschrägen 15 vorgesehen. Selbstverständlich muß es sich dabei nicht um reine Hilfsschrägen handeln. Vielmehr kann auch eine Rundung oder irgendeine andere geeignete Form vorgesehen werden, damit der Zapfen 5 ungehindert in die verschwenkte Position gelangen kann.

Es folgt nun die Beschreibung eines zweiten Ausführungsbeispiels einer erfindungsgemässen Verdindungsclipaufnahme bzw. Eingriffsaufnahme.

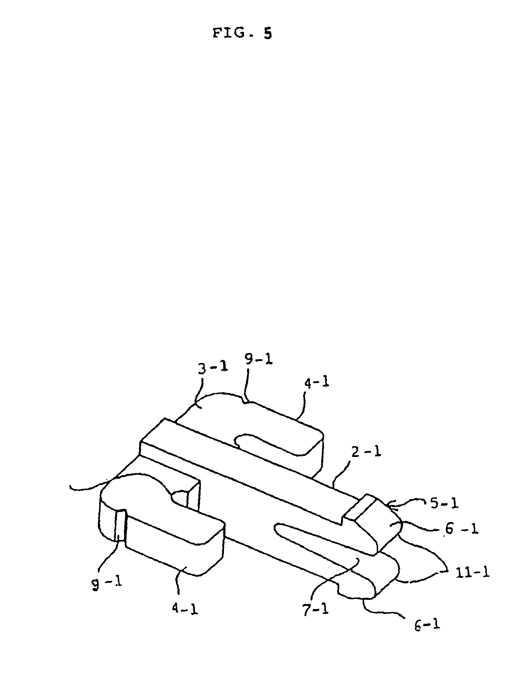

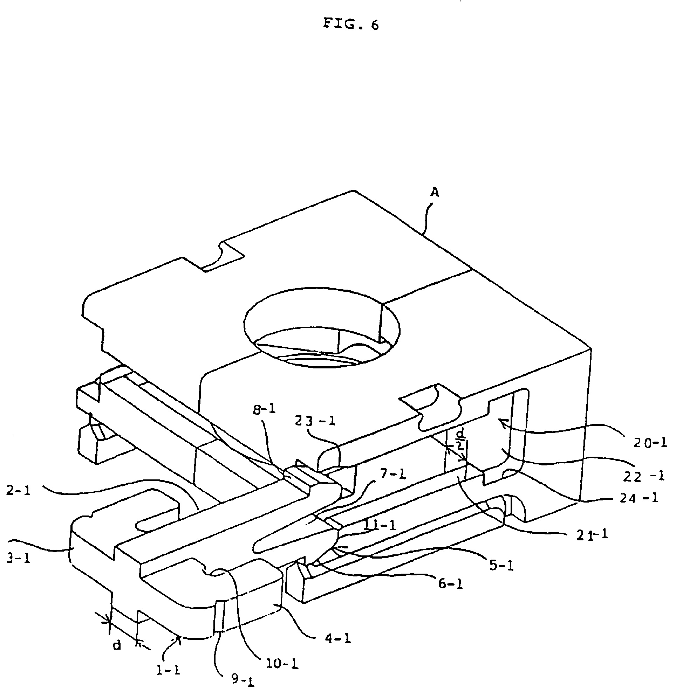

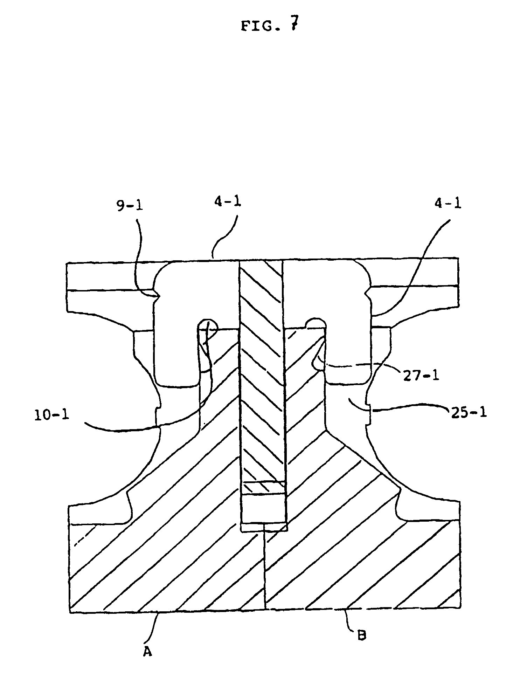

Im folgenden soll noch auf eine Besonderheit dieses Ausführungsbeispiels eingegangen werden, nämlich die mehrfache Einsetzbarkeit der Verbindungsclipaufnahme. Es muß nämlich nicht zwangsläufig immer der Verbindungsclip gemäß der vorliegenden Erfindung verwendet werden. Denkbar ist grundsätzlich auch die Nutzung eines anderen Verbindungsclip. Um dies zu ermöglichen, ist die vorhandene und soweit beschriebene Verbindungsclipaufnahme auf geschickte Art und Weise so gestaltet, daß sowohl ein Verbindungsclip der bisher beschriebenen Art als auch ein Verbindungsclip einer weiteren nicht erfindungsgemässen Art eingesetzt werden kann. Dieser andere Verbindungsclip ist in Fig. 5 dargestellt. Die Fig. 6 zeigt, wie der Verbindungsclip nach Fig. 5 in die Verbindungsclipaufnahme eingesetzt wird und Fig. 7 zeigt im Schnitt, wie der Verbindungsclip in die Verbindungsclipaufnahme eingesetzt ist.

Zunächst wird der Verbindungsclip 1-1 anhand von Figur 5 beschrieben.

Der Verbindungsclip hat im wesentlichen eine ankerförmige Gestalt. Er besteht aus einem Stab 2-1 und einem Ankerbalken 3-1, der an einem Ende des Stabs quer dazu einstückig ausgebildet ist. Der Stab 2-1 und der Ankerbalken 3-1 haben einen im wesentlichen rechtwinkligen Querschnitt und sind so angeordnet, daß der Stab 2-1 hochkant zum Ankerbalken 3-1 ausgerichtet ist.

Der Stab 2-1 weist an seinem anderen Ende ein Einschnappelement 5-1 auf. Das Einschnappelement 5-1 besteht aus einer V-förmigen Aussparung 7-1, die am unteren Ende des Stabs 2-1 geöffnet ist und nach innen zusammenläuft. Dadurch entstehen Fußteilhälften. An diesen Fußteilhälften sind Einschnappnasen 11-1 vorgesehen, die an der der V-förmigen Aussparung 7-1 abgewandten Seite des Stabs 2-1 vorstehen. Diese Einschnappnasen 11-1 haben eine Montagehilfsschräge 6-1 zur Erleichterung des Einschiebens des Verbindungsclips in eine entsprechende Nut in der zu verbindenden Einzelkomponente bei der späteren Montage. Durch die V-förmige Aussparung 7-1 ist der Stab 2-1 im unteren Bereich flexibel und kann beim Einschieben in eine Nut, die etwas kleiner als der Fußteil ist, etwas zusammengedrückt werden. Dadurch wird ein Einschieben in eine Ausnehmung ermöglicht, deren Breite etwas kleiner als die Breite ist, die der Fußteil mitsamt den Einschnappnasen wäre, da die Einschnappnasen einfach nach innen gebogen werden, um sich der Breite der Ausnehmung anzupassen.

Der Ankerbalken 3-1 hat an seinen beiden Endbereichen einen rechtwinklig gebogenen stiftartigen Einsteckabschnitt 4-1, der um ca. 90 Grad so gebogen ist, daß er sich etwa parallel zum Stab 2-1 erstreckt. Im Winkelbereich ist an der Innenseite eine Ausnehmung 10-1 vorgesehen, um die stiftartigen Einsteckabschnitte 4-1 mit einer gewissen Flexibilität auszustatten.

Im folgenden soll eine Verbindungsclipaufnahme, die in einem zu verbindenden Bauteil A, B vorgesehen ist und zum Aufnehmen des Verbindungsclips dient, näher erläutert werden. Dabei wird insbesondere auf Figur 6 verwiesen.

Die Verbindungsclipaufnahme ist zweimal vorgesehen und befindet sich an zwei gegenüberliegenden Seiten eines zu verbindenden Bauteils A, B. Dadurch kann ein zu verbindendes Bauteil wahlweise rechts oder links oder auch gleichzeitig an beiden Seiten mit einem oder zwei zu verbindenden Bauteilen verbunden werden. Eine solche Seite wird mit einer entsprechenden Seite einer weiteren Einzelkomponente B in Anlage gebracht werden und durch den Verbindungsclip 1-1 werden beide Bauteile zusammen fixiert (s. Fig. 7).

Die Verbindungsclipaufnahme besteht aus einer Nut 20-1, die an einer Seitenfläche der zu verbindenden Einzelkomponente A so ausgebildet ist, daß sie an einem Ende offen ist. Diese Nut 20-1 verläuft im wesentlichen langgestreckt von einer Einschubseite, der offenen Nutseite nämlich, ausgehend. Dabei ist am offenen Nutanfang eine Montagehilfsschräge 23-1 vorgesehen, die für einen leichteren Einschub des Verbindungsclips dient. Danach folgt ein Einführabschnitt 21-1, der eine Nutbreite hat, die in etwa der Breite des einzuschiebenden Stabs des Verbindungsclips entspricht. Da jedoch der Verbindungsclip eine Einschnappnase 11-1 aufweist, deren Breite sich über die normale Breite des Stabs 2-1 hinaus erstreckt, werden die Einschnappnasen 11-1 beim Passieren des Einführabschnitts 21-1 etwas zusammengedrückt. Dieses Zusammendrücken ist durch die V-Aussparung 7-1 möglich. An diesen Einführabschnitt 21-1 schließt sich ein Einschnappabschnitt 22-1 an. Der Einschnappabschnitt 22-1 weist eine Hinterschneidung 24-1 auf, deren Breite breiter als die Breite des Einführabschnitts 21-1 ist. Dadurch kann sich das Einschnappelement nach dem zusammengedrückten Zustand im Einführabschnitt 21-1 wieder ausdehnen und schnappt somit in die Hinterschneidung 24-1 ein.

Gemäß Fig. 6 hat die Nut 20-1 eine Nuttiefe d/2, die in etwa der halben Dicke d des Stabes 2-1 entspricht, so daß beim Einschieben des Verbindungsclips 1-1 nur eine Hälfte des Stabs in der Dickenerstreckung mit der Nut 20-1 der Verbindungsclipaufnahme in Eingriff gelangt. Die andere Hälfte steht nach außen vor.

Im folgenden wird der Zusammenbau zweier Einzelbauteile beschrieben. Zwei einzelne zu verbindende Bauteile A, B werden mit den zwei Seiten aneinander gelegt (s. Fig. 7), die jeweils die Verbindungsclipaufnahme aufweisen. Dadurch entsteht aus den zwei Nuten 20-1 eine sacklochartige Öffnung, die an ihrem Ende durch die Hinterschneidung 24-1 zum Einschnappabschnitt 22-1 verbreitert ist. Wenn der Verbindungsclip in die Nut 20-1 eingeschoben wird, werden die Einschnappnasen 11-1 des Schnappelementes 5-1 flexibel zusammengedrückt. Der Verbindungsclip wird so lange eingeschoben, bis die Einschnappnasen 11-1 in die Hinterschneidung 24-1 der Nut 20-1 in der Verbindungsclipaufnahme einrasten, d.h. daß sich die Einschnappnasen 11-1 aus ihrer zusammengedrückten Position wieder in ihre Normalstellung zurückverformen.

Gleichzeitig werden die stiftartigen Einsteckabschnitte 4-1 des Ankerbalkens 3-1 in entsprechende Einsteckaufnahmen 25-1, die zusätzlich in der Verbindungsclipaufnahme ausgebildet sind, eingeschoben. Dabei werden eventuell vorhandene Maßungenauigkeiten sowohl beim Verbindungsclip als auch bei der Verbindungsclipaufnahme durch die Flexibilität des stiftartigen Einsteckabschnitts 4-1 ausgeglichen. Die Flexibilität wird durch die Kerbe 9-1 herbeigeführt.

Indem die Einschnappnasen 11-1 des Verbindungsclips 1-1 in den Einschnappabschnitt 22-1 der Nut 20-1 der Verbindungsclipaufnahme einrasten, wird die Verbindung unlösbar, da die Einschnappnasen in der Hinterschneidung nicht mehr zugänglich sind. Durch das gleichzeitige Einführen der stiftartigen Einsteckabschnitte 4-1 in die entsprechenden Einsteckaufnahmen 25-1 wird ein Ausrichten aller Teile zueinander erreicht.

Der Verbindungsclip kann aus Kunststoff hergestellt sein. Dabei kann eine Kunststofformspritztechnik angewandt werden, die ein einstückiges Ausbilden des Verbindungsclips ermöglicht und somit für eine kostengünstige Herstellung sorgt. Gleiches gilt für die Herstellung der Verbindungsclipaufnahme, deren Herstellung bereits bei der Herstellung des zu verbindenden Bauteils berücksichtigt werden kann.

Durch die geeignete Auswahl des Kunststoffs kann der Verbindungsclip ferner mit einer gewünschten Flexibilität versehen werden. Durch das jeweilige Vorsehen der Verbindungsclipaufnahmen an zwei sich gegenüberliegenden Seiten eines zu verbindenden Bauteils A, B, können die Einzelkomponenten in beliebiger Anzahl in Reihe zusammengefügt werden.

Wie bei einem Vergleich des ersten Ausführungsbeispiels der Fig. 1 bis 4 mit dem zweiten Ausführungsbeispiel der Fig. 5 bis 7 hervorgeht, sind die Verbindungsclipaufnahmen beider Ausführungsbeispiele gleich ausgebildet. Sie sind so gestaltet, daß beide Verbindungsclips wahlweise eingesteckt werden können. Daß heißt, daß mehrere Funktionsflächen der Verbindungsclipaufnahmen eine doppelte Funktion haben, nämlich zum einen zur Aufnahme des Verbindungsclips des ersten Ausführungsbeispiels und zum anderen zur Aufnahme des Verbindungsclips des zweiten Ausführungsbeispiels.

Dabei entsprechen beispielsweise Teilbereiche der Nut 10 des ersten Ausführungsbeispiels Teilbereichen der Nut 22-1 des zweiten Ausführungsbeispiels. Ferner ist beispielsweise in Fig. 7 zu erkennen, daß die Einsteckaufnahme 25-1 zur Aufnahme des Einsteckabschnitts 4-1 des Verbindungsclips des zweiten Ausführungsbeispiels mit einer Hinterschneidung 27-1 ausgebildet ist, die der Hinterschneidung 11 der Verbindungsclipaufnahme des ersten Ausführungsbeispiels entspricht. Ferner ist in Fig. 6 erkennbar, daß die Verbindungsclipaufnahme des zweiten Ausführungsbeispiels eine Nut mit Hinterschneidung aufweist, wie sie zur Aufnahme des Verbindungsclips 1 des ersten Ausführungsbeispiels notwendig ist, die dort mit dem Bezugszeichen 7 bezeichnet ist.

Zusammenfassend kann man sagen, daß die Verbindungsclipaufnahme beider vorstehend beschriebenen Ausführungsbeispiele alle Merkmale aufweist, die zur wahlweisen Aufnahme der Verbindungsclips des ersten oder des zweiten Verbindungsclips notwendig sind. Somit ist die Konstruktion der Verbindungsclipaufnahme multifunktionell.

Die vorstehend beschriebene Erfindung ist insbesondere für elektrische Schaltgeräte wie Leitungsschutzschalter, Fehlerstromschutzschalter, Hilfsschalter oder ähnliches vorgesehen. Vorteilhafterweise sind dann alle Geräte einer Serie mit Verbindungsclipaufnahmen der obengenannten Art ausgestattet, so daß sie sich zu beliebigen Funktionseinheiten zusammensetzen lassen.

Soll beispielsweise eine Funktionseinheit aus drei oder vier Leitungsschutzschaltern gebildet werden, werden diese Geräte mit nicht lösbaren Verbindungsclips gemäß dem zweiten Ausführungsbeispiel verbunden. Zur Erzielung einer gewünschten Stabilität weisen dann alle Leitungsschutzschalter beispielsweise drei Clipaufnahmen auf. Dabei könnte jeweils eine im Bereich der Anschlußklemmen, wie in den Figuren gezeigt, und eine im Boden des Gerätes angeordnet sein.

Soll dagegen ein Hilfsschalter mit einem Leitungsschutzschalter kombiniert werden, wird der Hilfsschalter bereits werksseitig beispielsweise mit zwei lösbaren Verbindungsclips gemäß dem ersten Ausführungsbeispiel ausgestattet und damit dann in die Verbindungsclipaufnahmen des Leitungsschutzschalters eingeclipst.

Selbstverständlich müssen dabei alle Clipaufnahmen der Geräte einer Serie in derselben Höhe vorgesehen sein, da die verbundenen Geräte dann auf derselben Hutschiene angeordnet werden.

## Patentansprüche

1. Verbindungsclip (1) zur Verbindung zweier Bauteile, der ankerförmig geformt ist, bestehend aus:
einem Stab (3), der einen parallel zur Drehachsenrichtung eines Drehfußes (2) vorstehenden Zapfen (5) aufweist,
einem an einem Ende des Stabs (3) ausgebildeten Drehfuß (2), und
einem am anderen Ende des Stabs (3) ausgebildeten Ankerbalken (4), der sich quer zum Stab (3) erstreckt und an beiden Enden einen bauchigen Einschnappabschnitt (4a) aufweist,
wobei die Drehachse des Drehfußes (2) sowohl quer zur Ausrichtung des Ankerbalkens (4) als auch quer zur Ausrichtung des Stabs (3) steht.

2. Verbindungsclip (1) gemäß Anspruch 1, **dadurch gekennzeichnet, dass**
der Drehfuß (2) in der Drehachsenrichtung auf mindestens einer Seite axial relativ zum Stab (3) vorsteht.

3. Verbindungsclip (1) gemäß einem der vorangehenden Ansprüche, **dadurch gekennzeichnet, dass**
der Stab (3) und der Ankerbalken (4) flach ausgebildet sind.

4. Verbindungsclip (1) gemäß einem der vorangehenden Ansprüche, **dadurch gekennzeichnet, dass**
der Ankerbalken (4) auf einer dem Stab (3) abgewandten Seite eine Kerbe (6) aufweist.

5. Verbindungsclipaufnahme zur Aufnahme eines Verbindungsclips gemäß einem der vorangehenden Ansprüche, die in einem zu verbindenden Bauteil (13, 14) vorgesehen ist, bestehend aus:
einer zumindest an einem Ende offenen Nut (7) für die Führung des Stabs (3) des Verbindungsclips, welche eine Hinterschneidung (9) aufweist, wobei die Hinterschneidung zumindest am offenen Ende der Nut (7) vorher endet, so dass eine Anlagefläche (12a) gebildet ist, die als Drehlagerung (12) für den Drehfuß (2) des Verbindungsclips (1) dient.

6. Verbindungsclipaufnahme gemäß dem vorhergehenden Anspruch, **dadurch gekennzeichnet, dass**
die Hinterschneidung (9) der Nut (7) an beiden seitlichen Enden der Nut vorher endet, so dass an beiden Enden jeweils eine Anlagefläche (12a) gebildet wird, die als Drehlagerung (12) für den Drehfuß (2) des Verbindungsclips (1) dient.

7. Eingriffsaufnahme in einem zu verbindenden Bauteil (13, 14) mit einem Verbindungsclip (1) gemäß einem der vorhergehenden Ansprüche 1 bis 4, bestehend aus einer Ausnehmung (11), die eine Form aufweist, die in etwa der Negativform eines Eingriffsflächenabschnitts einer Hälfte des Ankerbalkens entspricht.

8. Eingriffsaufnahme gemäß dem vorhergehenden Anspruch, **dadurch gekennzeichnet, dass**
eine solche Ausnehmung (11) in beiden Eckbereichen des zu verbindenden Bauteils (13, 14) vorgesehen ist, um wahlweise rechts und/oder links eine Hälfte des Ankerbalkens aufnehmen zu können.

9. Eingriffsaufnahme gemäß den beiden vorhergehenden Ansprüchen, **dadurch gekennzeichnet, dass**
die Ausnehmung (11) eine Hinterschneidung aufweist.

10. Verbindungsclipaufnahme gemäß einem der Ansprüche 5 und 6 bzw. Eingriffsaufnahme gemäß einem der Ansprüche 7 bis 9, **dadurch gekennzeichnet, dass**
an der Außenseite des zu verbindenden Bauteils, die als Anlageseite für ein damit zu verbindendes Bauteil dient, eine abschnittsweise Zurücksetzung (8) vorgesehen ist.

11. Verbindungsclipaufnahme gemäß dem vorhergehenden Anspruch, **dadurch gekennzeichnet, dass**
beim korrespondierenden Anlegen eines zweiten derartig ausgebildeten zu verbindenden Bauteils eine gemeinsame Nut (10) ausgebildet ist.

12. Verbindungsclipaufnahme gemäß einem der vorhergehenden Ansprüche 5, 6, 10, 11, **dadurch gekennzeichnet, dass**
am Eingangsbereich der abschnittsweisen Zurücksetzung (8) eine Montagehilfsschräge vorgesehen ist.

13. Verbindungsclipaufnahme bzw. Eingriffsaufnahme gemäß einem der Ansprüche 10 bis 12, **dadurch gekennzeichnet, dass**
die abschnittsweise Zurücksetzung (8) zu einer Nut (20-1) weitergebildet ist, wobei die Nut (20-1) einen Einführabschnitt (21-1) und einen breiteren Einschnappabschnitt (22-1) aufweist, so dass bezüglich des Einführabschnitts (21-1) eine Hinterschneidung (24-1) ausgebildet ist, und dass ferner
eine Einsteckaufnahme (25-1) vorgesehen ist, die sich parallel zur Nut (20-1) neben dieser ins Innere des zu verbindenden Bauteils (13, 14; A, B) erstreckt.

14. Verbindungsclipaufnahme gemäß dem vorhergehenden Anspruch, **dadurch gekennzeichnet, dass**
die Nut (20-1) am offenen Ende ein Paar Montagehilfsschrägen (23-1) an den gegenüberliegenden Nutwänden aufweist.

15. Verbindungsclipaufnahme in einem zu verbindenden Bauteil gemäß einem der vorhergehenden Ansprüche 5, 6, 10-14, **dadurch gekennzeichnet, dass**
mehrere Nuten (20-1) sowie mehrere Einsteckaufnahmen (25-1) in einem zu verbindenden Bauteil (13, 14; A, B) vorgesehen sind.

16. Elektrisches Bauteil mit einer Verbindungseinrichtung bestehend aus einem Verbindungsclip gemäß einem der Ansprüche 1 bis 4 und einer Verbindungsclipaufnahme gemäß einem der Ansprüche 5, 6 oder 10 bis 12, und einer Eingriffsaufnahme gemäß einem der Ansprüche 7 bis 9 -oder einer Verbindungsclipaufnahme bzw. Eingriffsaufnahme gemäß einem der Ansprüche 13 bis 15.

17. Elektrisches Bauteil mit einem Gehäuse, **dadurch gekennzeichnet, dass**
an dem Gehäuse an einer Mehrzahl von voneinander beabstandeten Stellen eine Verbindungsclipaufnahme bzw. eine Eingriffsaufnahme nach einem der Ansprüche 5 bis 15 vorgesehen ist.

18. Elektrisches Bauteil gemäß dem vorstehenden Anspruch,
**dadurch gekennzeichnet, dass**
das Gehäuse aus zwei Gehäusehälften besteht, wobei vor dem Zusammenbau des Gehäuses ein Verbindungsclip nach einem der Ansprüche 1 bis 4 eingesetzt wird.

## Claims

1. Connecting clip (1) for connecting two components which is anchor-shaped and comprises:
a stem (3) possessing a pin (5) projecting parallel to the axis of rotation of a rotating foot (2), a rotating foot (2) formed on the end of the stem (3), and
an anchor bar (4) formed on the other end of the stem (3) which extends transversely to the stem (3) and possesses a bulging snap-in section (4a),
whereby the axis of rotation of the rotating foot (2) is aligned both transversely to the alignment of the anchor bar (4) and also transversely to the alignment of the stem (3).

2. Connecting clip (1) in accordance with claim 1, **characterised in that**
the rotating foot (2) projects axially in the direction of the axis of rotation relative to the stem (3) on at least one side.

3. Connecting clip (1) in accordance with one of the preceding claims, **characterised in that** the stem (3) and the anchor bar (4) are flat in form.

4. Connecting clip (1) in accordance with one of the preceding claims, **characterised in that** the anchor bar (4) possesses a notch (6) on a side facing away from the stem (3).

5. Receiving fixture for a connecting clip in accordance with one of the preceding claims, which is provided in a component (13, 14) which is to be connected, comprising:
a groove (7), open at at least one end, to guide the stem (3) of the connecting clip which possesses an undercut (9), whereby the undercut ends prematurely at least at the open end of the groove (7) so that a contact surface (12a) is formed which serves as a rotary bearing (12) for the rotating foot (2) of the connecting clip (1).

6. Receiving fixture for a connecting clip in accordance with one of the preceding claims,
**characterised in that**
the undercut (9) of the groove (7) ends prematurely at both lateral ends of the groove, so that a contact surface (12a) is formed at both ends which serves as a rotary bearing (12) for the rotating foot (2) of the connecting clip (1).

7. Engaging fixture in a component (13, 14) which is to be connected, with a connecting clip (1) in accordance with one of the preceding claims 1 to 4, comprising a recess (11) which has a form roughly corresponding to the negative shape of an engaging surface section of one half of the anchor bar.

8. Engaging fixture in accordance with one of the preceding claims, **characterised in that** one such recess (11) is provided in both corner areas of the component (13, 14) which is to be connected in order to allow one half of the anchor bar to be received on the right and/or left, selectively.

9. Engaging fixture in accordance with one of the two preceding claims, **characterised in that** the recess (11) possesses an undercut.

10. Receiving fixture for a connecting clip in accordance with one of claims 5 and 6 or engaging fixture in accordance with one of claims 7 to 9, **characterised in that** a section-wise rebate (8) is provided on the outside of the component which is to be connected which serves as a contact surface for the component which is to be connected with it.

11. Receiving fixture for a connecting clip in accordance with one of the preceding claims, **characterised in that**
when a second component, of such design, which is to be connected is placed in contact correspondingly, a common groove (10) is formed.

12. Receiving fixture for a connecting clip in accordance with one of the preceding claims, **characterised in that**
a bevel facilitating assembly is provided in the entry area of the section-wise rebate (8).

13. Receiving fixture for a connecting clip or engaging fixture in accordance with one of claims 10 to 12, **characterised in that**
the section-wise rebate (8) is continued to form a groove (20-1), said groove (20-1) possessing an insertion section (21-1) and a wider snap-in section (22-1), so that an undercut (24-1) is formed in relation to the insertion section (21-1), and that, in addition, a plug-in receiving fixture (25-1) is provided which extends parallel to, and next to, the groove (20-1) leading into the inside of the component which is to be connected (13, 14; A, B).

14. Receiving fixture for a connecting clip in accordance with one of the preceding claims, **characterised in that**
the groove (20-1) possesses at the open end a pair of bevels facilitating assembly on the opposing walls of the groove.

15. Receiving fixture for a connecting clip in a component which is to be connected in accordance with one of the preceding claims 5, 6, 10-14, **characterised in that**
several grooves (20-1) and several plug-in receiving fixtures (25-1) are provided in a component which is to be connected (13, 14; A, B).

16. Electrical component with a connecting device comprising a connecting clip in accordance with one of claims 1 to 4 and a receiving fixture for a connecting clip in accordance with one of claims 5, 6 or 10-12, and an engaging fixture in accordance with one of claims 7 to 9, or a receiving fixture for a connecting clip or engaging fixture in accordance with one of claims 13 to 15.

17. Electrical component with a housing, **characterised in that** a receiving fixture for a connecting clip or engaging fixture in accordance with one of claims 5 to 15 is provided on the housing at a plurality of points spaced at intervals.

18. Electrical component in accordance with the preceding claim,
**characterised in that**
the housing consists of two housing halves, whereby a connecting clip in accordance with one of claims 1 to 4 is inserted before the housing is assembled.

## Revendications

1. Clip de raccordement (1) pour relier deux composants, ce clip ayant la forme d'une ancre constituée de :
- une tige (3) qui présente un pivot (5) disposé en saillie et parallèle à la direction de l'axe d'un pied rotatif (2),
- un pied rotatif formé à une extrémité de la tige (3),
- une barre d'ancre (4) située à l'autre extrémité de la tige (3) à laquelle elle est perpendiculaire et qui présente à chacune de ses deux extrémités une section d'encliquetage (4a) de forme bombée;
étant précisé que l'axe de rotation du pied (2) est perpendiculaire à la fois à la direction de la barre d'ancre (4) et à la direction de la tige (3).

2. Clip de raccordement (1) selon la revendication 1, **caractérisé en ce que** le pied rotatif (2) fait saillie sur au moins un côté de la barre (3) selon la direction de son axe de rotation.

3. Clip de raccordement (1) selon la revendication 1 ou 2, **caractérisé en ce que** la tige (3) et la barre d'ancre (4) ont une forme plate.

4. Clip de raccordement (1) selon une des revendications précédentes, **caractérisé en ce que** la barre d'ancre (4) présente une entaille (6) située à l'opposé de la tige (3).

5. Logement de clip de raccordement pour accueillir un clip selon une des revendications précédentes et qui est prévu dans un composant à raccorder (13, 14), ce logement étant composé d'une rainure (7) ouverte à au moins une extrémité pour assurer le guidage de la tige (3) du clip de raccordement, et qui présente une contre-dépouille (9) se terminant en avant au moins sur l'extrémité ouverte de la rainure (7) de manière à former une portée d'appui (12a) qui sert de coussinet de pivotement (12) du pied rotatif (2) du clip de raccordement (1).

6. Logement de clip de raccordement selon la revendication 5, **caractérisé en ce que** la contre-dépouille (9) de la rainure (7) se termine en avant sur les deux extrémités latérales de la rainure, de manière à former sur chaque extrémité une portée d'appui (12a) qui sert de coussinet de pivotement (12) du pied rotatif (2) du clip de raccordement (1).

7. Logement d'engagement dans une pièce à raccorder (13, 14) au moyen d'un clip de raccordement (1) selon une des revendications 1 à 4, constitué d'un évidement (11) dont la forme correspond sensiblement au négatif d'une section plate d'engagement d'une moitié de la barre d'ancre.

8. Logement d'engagement selon la revendication 7, **caractérisé en ce qu'**un évidement (11) est prévu dans les deux zones de coin du composant à raccorder (13, 14) pour pouvoir au choix accueillir à droite et/ou à gauche une moitié de la barre d'ancre.

9. Logement d'engagement selon les revendications 7 et 8, **caractérisé en ce que** l'évidement (11) présente une contre-dépouille.

10. Logement de clip de raccordement selon la revendication 5 ou 6 et logement d'engagement selon une des revendications 7 à 9, **caractérisés en ce que** sur la face externe du composant à raccorder et qui sert de face d'appui pour un composant à lui raccorder, il est prévu localement une partie en retrait (8).

11. Logement de clip de raccordement selon la revendication 10, **caractérisé en ce que** par application en correspondance d'un second composant à raccorder constitué de la même manière, une rainure commune (10) est formée.

12. Logement de clip de raccordement selon une des revendications 5, 6, 10, 11, **caractérisé en ce que** dans la zone d'entrée de la partie en retrait (8) il est prévu un chanfrein d'aide au montage.

13. Logement de clip de raccordement et logement d'engagement selon une des revendications 10 à 12, **caractérisés en ce que** la partie en retrait (8) est élargie pour donner une rainure (20-1) qui présente une section d'engagement (21-1) et une section d'encliquetage (22-1) plus large, de sorte qu'une contre-dépouille (24-1) est formée par rapport à la section d'engagement (21-1), et il est prévu de plus un logement d'enfichage (25-1) parallèle à la rainure (20-1) et disposé à côté de celle-ci à l'intérieur du composant à raccorder (13, 14 ; A, B).

14. Logement de clip de raccordement selon la revendication 13, **caractérisé en ce que** la rainure (20-1) présente à son extrémité ouverte une paire de chanfreins d'aide au montage (23-1) réalisés sur les parois opposées de la rainure.

15. Logement de clip de raccordement dans un composant à raccorder selon une des revendications 5, 6, 10 à 14 **caractérisé en ce que** plusieurs rainures (20-1) ainsi que plusieurs logements d'enfichage (25-1) sont prévus dans un composant à raccorder (13, 14 A, B).

16. Composant électrique comprenant un dispositif de raccordement composé d'un clip de raccordement selon une des revendications 1 à 4, d'un logement de clip de raccordement selon une des revendications 5, 6 ou 10 à 12, et d'un logement d'engagement selon une des revendications 7 à 9 ou d'un logement de clip de raccordement et d'un logement d'engagement selon une des revendications 13 à 15.

17. Composant électrique comprenant un boîtier, **caractérisé en ce que** sur le boîtier est prévu en une pluralité d'endroits espacés les uns des autres un logement de clip de raccordement et un logement d'engagement selon une des revendications 5 à 15.

18. Composant électrique selon la revendication 17, **caractérisé en ce que** le boîtier est composé de deux moitiés de boîtier, et avant leur assemblage, un clip de liaison selon une des revendications 1 à 4 est monté.
